(19) Europäisches Patentamt

European Patent Office

Office européen des brevets

(11) EP 0 568 830 B2

## (12) NEW EUROPEAN PATENT SPECIFICATION

(45) Date of publication and mention
of the opposition decision:
**21.04.1999 Bulletin 1999/16**

(51) Int Cl.⁶: **H01S 3/025**, H01L 33/00,
G11B 7/125

(45) Mention of the grant of the patent:
**04.09.1996 Bulletin 1996/36**

(21) Application number: 93105799.6

(22) Date of filing: **07.04.1993**

(54) **Semiconductor laser device**

Halbleiterlaservorrichtung

Dispositif laser à semi-conducteur

(84) Designated Contracting States:
**DE FR GB NL**

(30) Priority: **07.04.1992 JP 85323/92**
**22.01.1993 JP 8679/93**

(43) Date of publication of application:
**10.11.1993 Bulletin 1993/45**

(73) Proprietor: **FUJI ELECTRIC CO., LTD.**
**Kawasaki-shi Kanagawa 210 (JP)**

(72) Inventors:
- **Kitamura, Shoji, c/o Fuji Electric Co. Ltd.**
  **Kanagawa (JP)**
- **Shindo, Yoichi, c/o Fuji Electric Co. Ltd.**
  **Kanagawa (JP)**
- **Amano, Akira, c/o Fuji Electric Co. Ltd.**
  **Kanagawa (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 466 975**    **DE-A- 3 329 107**
**DE-A- 4 025 163**    **FR-A- 2 127 239**
**US-A- 4 403 243**

- **PATENT ABSTRACTS OF JAPAN vol. 10, no. 54 (E-385)4 March 1986 &JP-A-60 206 185**
- **PATENT ABSTRACTS OF JAPAN vol. 8, no. 36 (E-227)16 February 1984 & JP-A-58 194 381**
- **PATENT ABSTRACTS OF JAPAN vol. 9, no. 126 (E-318)31 May 1985 & JP-A-60 012 782**
- **PATENT ABSTRACTS OF JAPAN vol. 14, no. 359 (E-959)3 August 1990 && JP-A-02 125 687**
- **PATENT ABSTRACTS OF JAPAN vol. 14, no. 182 (E-916)12 April 1990 & JP-A-02 033 979**
- **PATENT ABSTRACTS OF JAPAN vol. 14, no. 533 (E-1005)22 November 1990 & JP-A-02 224 359**

**Description**

BACKGROUND OF THE INVENTION

Filed of the Invention

The present invention relates to semiconductor laser devices of the mold-type in which a laser diode element is encapsulated in a sealing resin layer, and more particularly to a semiconductor laser device that experiences minimal displacement of its light emitting point during continuously operation and/or during changing ambient conditions.

Discussion of the Prior Art

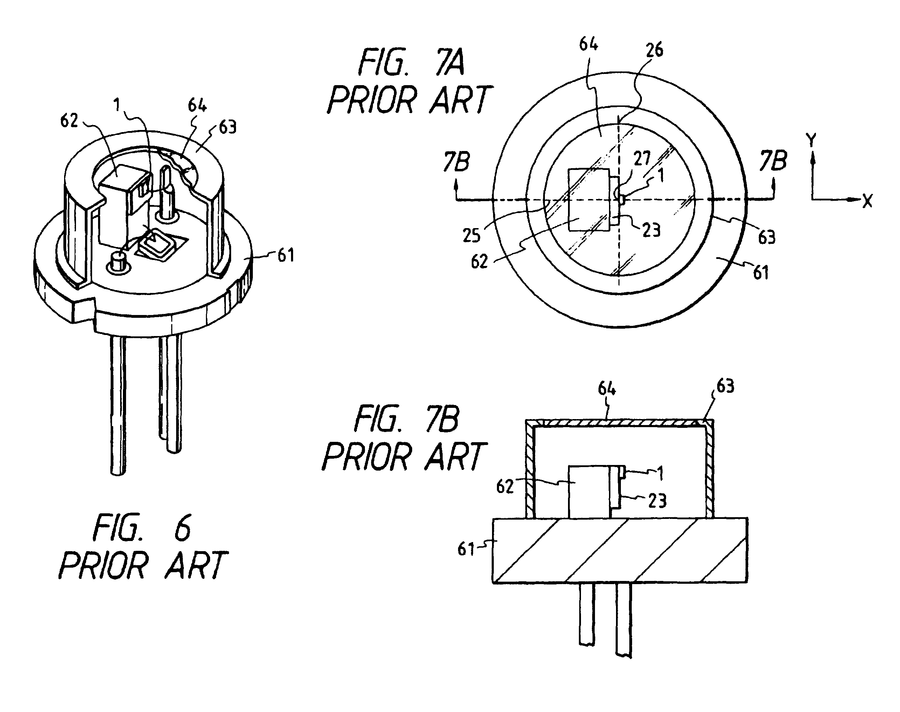

A semiconductor laser device of the can-type as shown in Figs. 6 and 7 is known in the art. As shown in Fig. 6, a laser diode element 1 is soldered to a radiator 62 supported on a stem 61. A cap 63 with a glass window 64 is soldered to the stem 61. In the semiconductor laser device shown in Figs. 7A and 7B, a laser diode element 1 is mounted to a submount provided by a photo diode 23, which is then mounted on a radiator 62 extending upwardly from the stem 61. The photo diode 23 submount also serves as a radiator plate. The laser diode element 1 is covered with a cap 63 also fastened to the stem 61. The combination of the radiator 62 and the photo diode 23 are positioned so that the laser diode element 1 is located at the center of the glass window 64 in cap 63, as viewed from the front; the center being designated by an intersection point 27 of a horizontal center line 25 (at a right angle to the major surface of the radiator 62, or an X-axis direction) and a vertical center line 26 (parallel to the major surface of the radiator 62, or a Y-axis direction).

Another semiconductor laser device of a resin sealing or mold-type has been developed. This type of laser device is less expensive and can be shaped more flexibly than the can-type laser device disclosed above. The mold-type laser device is described in detail in Published Unexamined Japanese Patent Application No. Hei. 2-125687. In this device, as shown in Fig. 8 herein, a laser diode element 1 is mounted on a submount 23 and then sealed in a sealing resin layer 11 comprised of transparent epoxy resin, for example. The element 1 is electrically powered through lead frames 20 and a gold wire 21. The semiconductor laser device of the mold-type has been known as a light emitting device of low light density per unit area, analogous to an LED.

The laser device of the mold-type is advantageous because of low manufacturing cost and the resin sealing layer can be of a wide variety of shapes. Additionally, the laser diode element can be used in high light density applications without any characteristic deterioration owing to light damage if an end face destruction preventing layer is used.

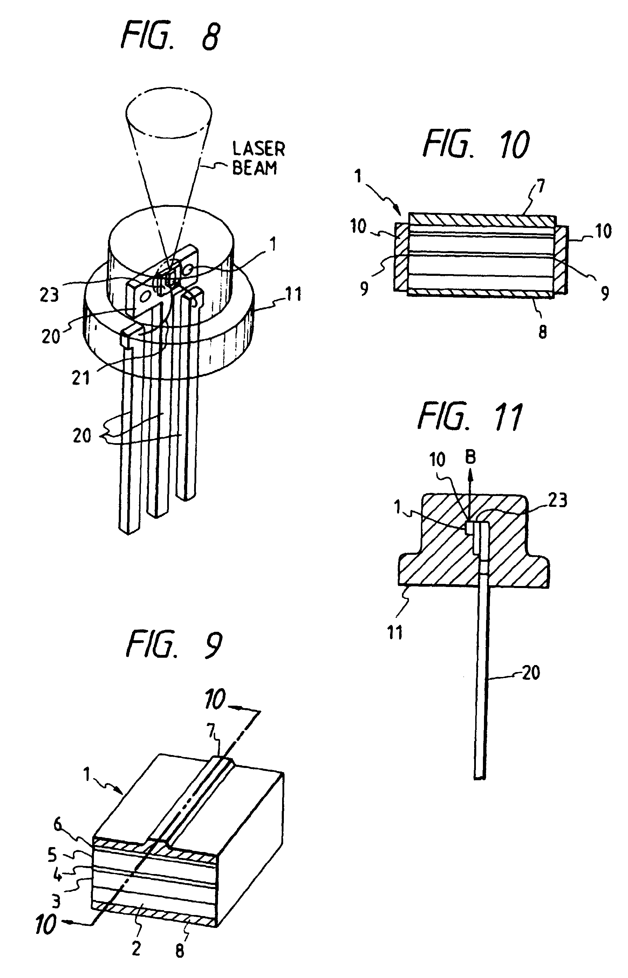

One example of a prior art laser device will be described with reference to Figs. 9 through 12. The laser diode element 1 is illustrated as having a DH (double heterodyne junction) structure. As shown, an n-type clad layer 3 made of AlGaAs, an active layer 4, a p-type clad layer 5, and a p-type cap layer 6 made of GaAs are layered on an n-type GaAs substrate 2. An electrode 7 is selectively formed on the obverse side of the laser diode element in an opened portion of the p-type cap layer 6. An electrode 8 is formed on the rear side of the substrate 2. End-face destruction preventing layers 10 (Fig. 10) are respectively formed on the light emitting end faces of the laser diode element and are irradiated with laser beams. The end-face destruction preventing layers 10 are made of organic resin, which exhibits high heat resistance and low absorption coefficient in the wavelength region of the emitted laser beams.

As best illustrated in Fig. 11, the laser diode element 1 is mounted on a photo diode 23 serving also as a submount layer and a radiator plate. The photo diode 23 is mounted on the top end portion of the center lead frame of laterally arrayed lead frames 20. The photodiode 23 and the p-type cap layer 6 are connected to the respective lead frames 20 by bonding wires, for example, gold wires (not shown). The laser diode element 1, connected to those lead frames 20, is enclosed by resin 11, such as transparent epoxy resin, in a sealing manner. The semiconductor laser device of the mold-type, which includes the laser diode element 1 having the end-face destruction preventing layers 10, is low in cost and good in endurance.

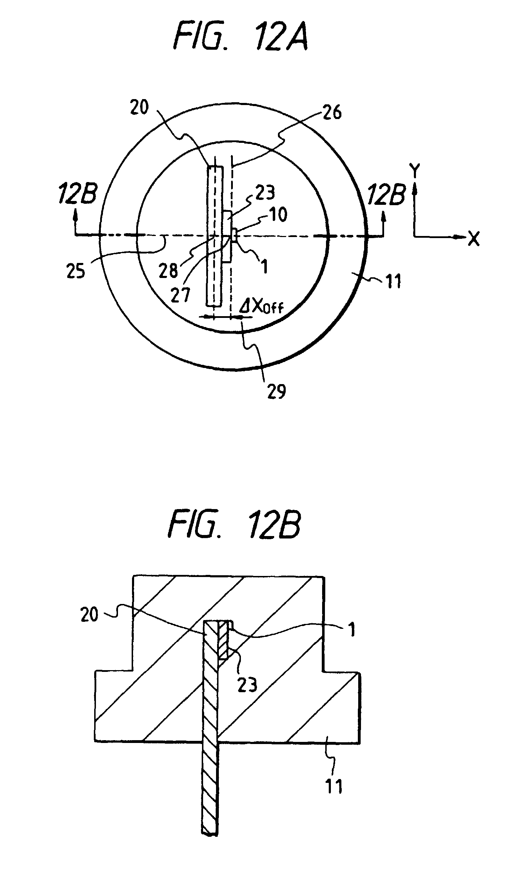

In the semiconductor laser device of the mold-type, as shown in Figs. 12A and 12B, the laser diode element 1 is positioned at or near the center the sealing resin layer 11, which is designated by intersection point 27 of the X axis 25 and the Y axis 26, as in the semiconductor laser device of the can-type. The center 28 of the lead frame 20 is displaced by distance $\Delta X_{off}$ (or offset 29), from the intersection point 27 of the sealing resin layer 11, because of the total thickness of the laser diode element 1, the photo diode 23 and the lead frame 20.

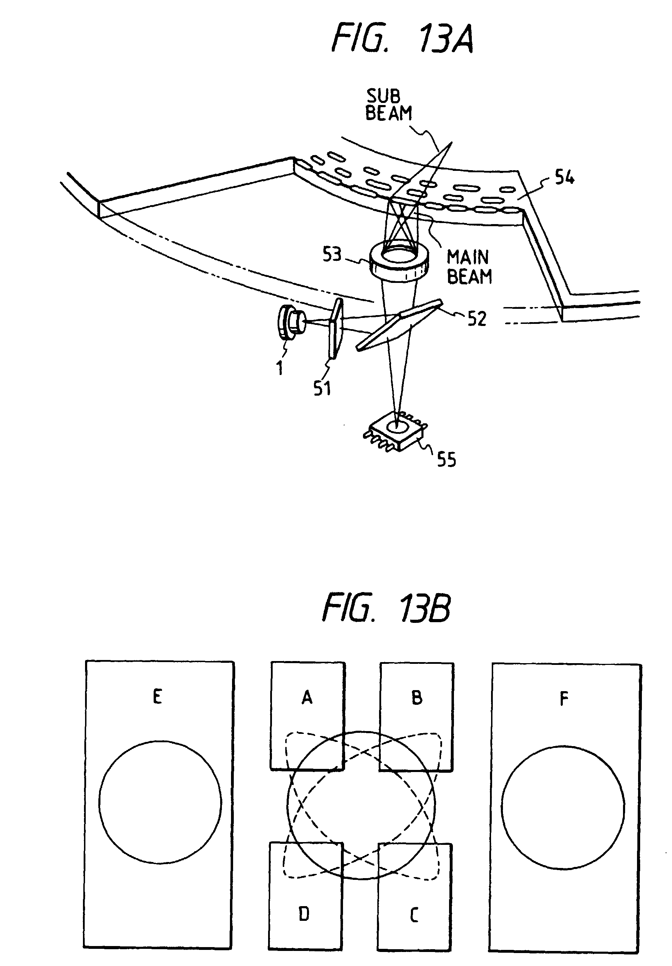

Those semiconductor laser devices are assembled into various types of optical systems. A typical example of the optical system is a pick-up device for an optical disc as schematically illustrated in Fig. 13A.

In the pick-up device illustrated, a laser beam emitted from the laser diode element 1 passes through a diffraction grating 51, turned 90° by a half mirror 52, and focused on the surface of a disc 54 through an objective lens 53. The laser beam is separated into a main beam and a subbeam by the diffraction grating 51. The subbeam is used for tracking servo purposes. The laser beam, reflected by the disc, 54 passes through the objective lens 53 and the half mirror 52 again and is projected onto the light sensor 55. The sensor transforms the received laser beam into a corresponding electrical signal.

The light sensor 55 consists of six photo diodes A to F, as shown in Fig. 13B. The main beam is incident on the quartered diodes A to D. The laser beam experiences astigmatism as it passes through the half mirror 52, and the shape of the main beam changes as indicated by the dotted lines in Fig. 13B, depending on the location of the photo diodes.

The focusing servo mechanism positions the objective lens 53 so that $(A + C) - (B + D) = 0$ where A, B, C and D are outputs of the photo diodes A, B, C and D. The "gravity center of beam on the photo diodes", to be discussed later, is defined as

$$[X, Y] = [\{(A + B) - (C + D)\}/(A + B + C + D),\{(A +D) - (B + C)\}/(A + B + C + D)]$$

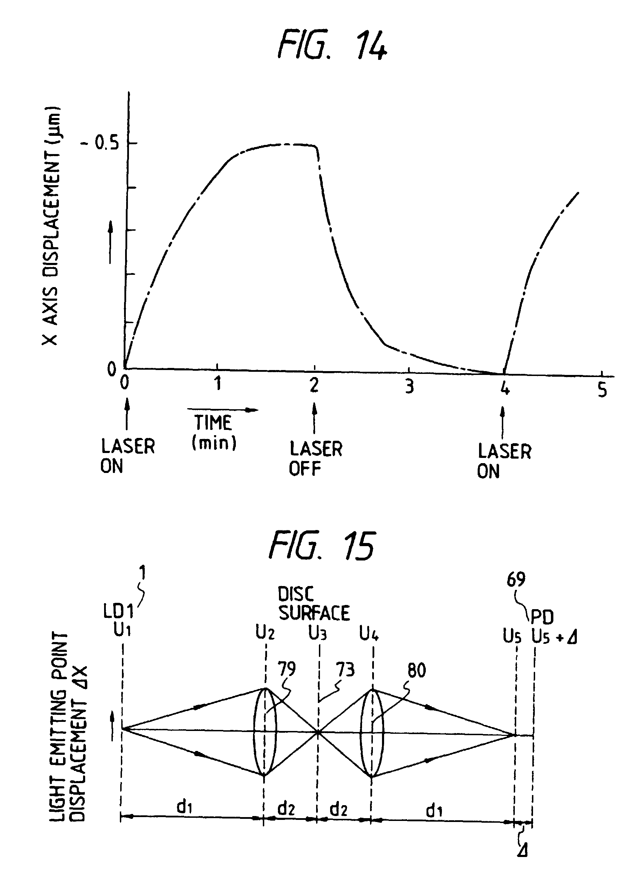

In the semiconductor laser device of the mold-type, it has been discovered that the light emitting point, i.e., the origin of the emitted laser beam, shifts location when the laser device is continuously operated and/or ambient conditions change. Shifting or displacement of the light emitting point is graphically represented in Fig. 14. To plot the graph of the figure, a mold-type semiconductor laser device was operated at room temperature while being fed with an operating current of 50 mA. In the graph, the abscissa represents time in minutes, and the ordinates represents the extent of displacement in the X-axis direction (normal to the lead frame surface. As seen from the graph, after about two minutes of laser emission, the light emitting point was displaced 0.5 μm in the - X-axis direction (i.e., toward the lead frame 20). After the device was turned off for about two minutes, the light emitting point returned to the original center point (moved in the + X-axis direction, or toward the laser diode). When the semiconductor laser device is assembled into a pick-up device, the extent of displacement of the gravity center of the beam on the photo diodes depends on the duration of continuous laser device operation and/or changes in ambient temperature.

The semiconductor laser device was operated at an output power of 3 mW at ambient temperatures from -10°C to 60°C. The gravity center of beam on the photo diodes was found to be displaced 10 μm or more. Minimization of the displacement of the light emitting point is essential in order that the semiconductor laser devices of the mold-type, which has many advantages, acquire the excellent performance achieved by can-type semiconductor laser devices.

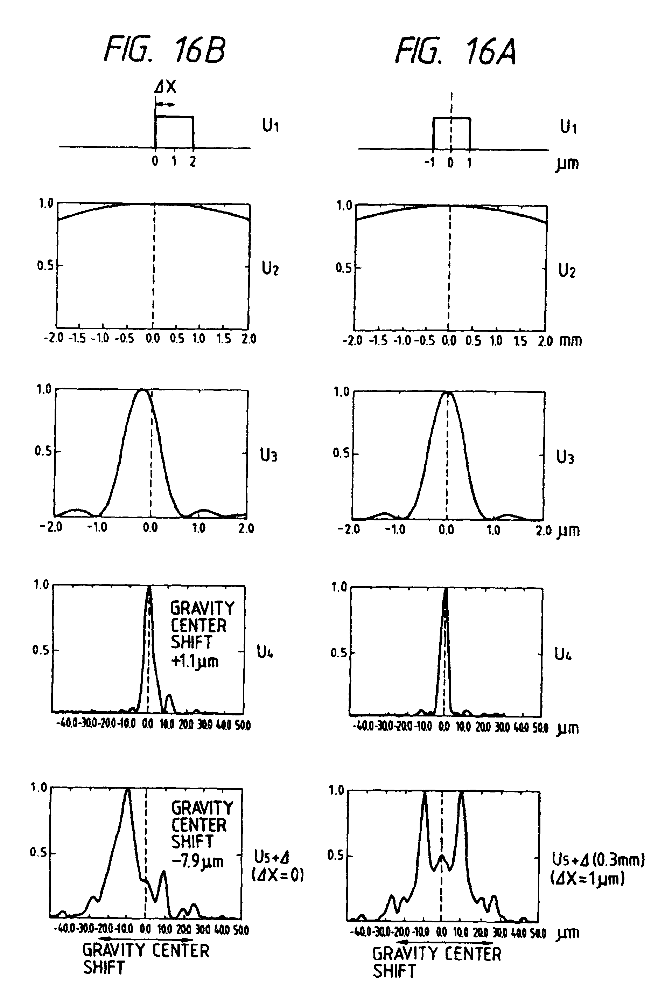

Turning to Fig. 15, there is shown a simulation model of the influence of light emitting point displacement when the laser device operates in a pick-up device. In the simulation, a one-dimensional optical system was utilized, in which a laser beam from a laser diode LD1, located on the left side, passes through a convex lens 79, separated from the diode LD1 by a distance dl, and the laser beam, reflected by a disc 73, then passes through another convex lens 80 to be focused on a photo diode (PD) 69. The one-dimensional system was treated as a double Fourier transform optical system. A light intensity distribution U2 on the convex lens 79, a light intensity distribution U3 on the disc 73, a complex amplitude U4 on the convex lens 80, and a light intensity distribution U5 +Δ were calculated using Fresnel's diffraction formula, with the assumption that the light intensity distribution U1 on the laser diode element 1 is rectangular in shape, is centered at ΔX and has a width of 2 μm. The ΔX corresponds to the extent of displacement of the light emitting point of the laser diode. The results of the calculations using the parameters in Table 1 are shown in Fig. 16.

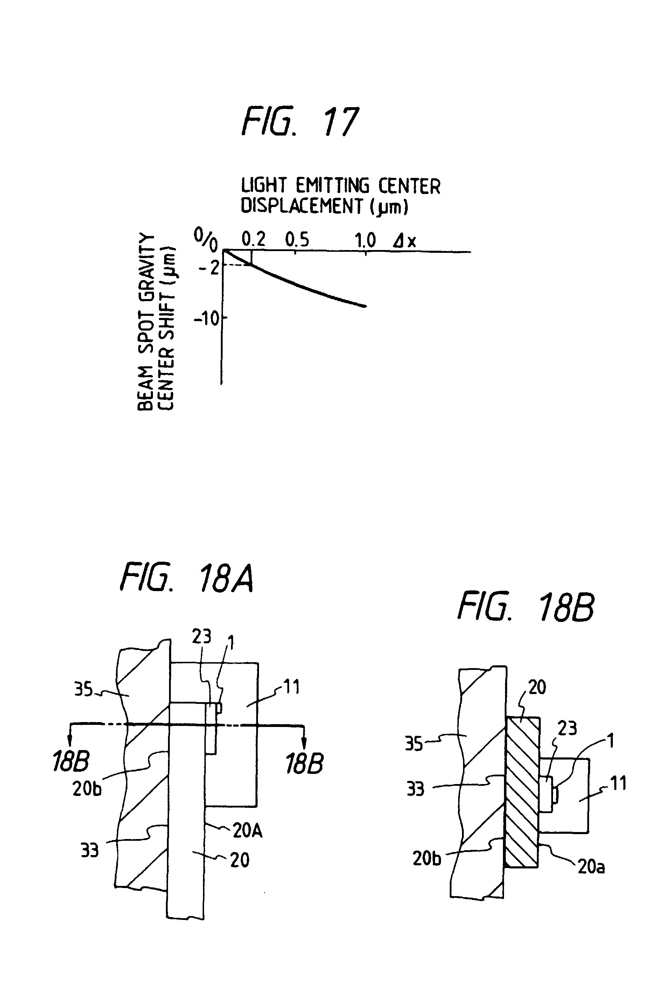

Fig. 16A is a graphical representation of the light distributions U1, U2, U3, U4 and U5 + ΔX = 0, and Fig. 16B is a graphical representation of the same when ΔX = 1 μm. A beam spot gravity center on the photo diode can be calculated using the light intensity distribution (U5 + Δ) on the photo diode. When the displacement quantity ΔX of the light emitting point was 1 μm, a shift of the beam spot gravity point, when calculated, was 7.9 μm. Similar calculations were repeated for other quantities of the displacement. The results of the calculation showed the relationship between the quantity of displacement of the light emitting point and the quantity of shift of the beam spot gravity center on the photo diode, as shown in Fig. 17. Thus, in an pick-up optical system, 1 μm displacement of the light emitting point produces a 7.9 times larger shift in the beam spot gravity center on the surface of the photo diode. This value is defined as a coupling magnification M between the laser diode element and the photo diode. The coupling magnification M is determined by the magnification of the lens system and the distance of the optical path between the light emitting point of the laser diode element 1 and the signal detection, divided photodiode. Accordingly, the coupling magnification M differs with the construction of the optical pick-up device.

Table 1

| Δx | 1.0 μm |
|----|--------|
| d1 | 25.0 μm |
| f | 3.9 μm |

Table 1   (continued)

| d2 | 4.6 μm |
|---|---|
| lens diameter | 4.0 μm |
| Δ | 0.3 μm |
| Note: For the symbols in the table, refer to Fig. 15. | |

In the conventional semiconductor laser device, the extent of the shift of the beam spot on the photo diode 69 can exceed a tolerable value. Accordingly, a mechanism to adjust the displacement of the light emitting point or a mechanism to follow the shift of the beam spot gravity center is required for the conventional semiconductor laser device.

Thus, the semiconductor laser device of the mold-type is advantageous in that it is inexpensive and can be flexibly shaped. However, when it is utilized in an application requiring good light emitting point stability, an additional adjusting mechanism is required. This negates the advantages of laser devices of the mold-type.

SUMMARY OF THE INVENTION

The present invention has been made in view of the above circumstances and has an object to provide a semiconductor laser device of the mold-type which has less displacement of the light emitting point, and hence is directly applicable for devices requiring good stability of the light emitting point, such as a pick-up device in an optical system for a compact disk.

To solve the problems of conventional semiconductor laser devices the inventors carefully studied the relationship between the lead frame supporting the laser diode element and the sealing resin layer for sealing the lead frame and the laser diode element and have succeeded in minimizing the shift of the lead frame, which is caused by the sealing resin layer.

According to the present invention. a semiconductor laser device, having a lead frame for electrically controlling a laser diode element having at least an end face for emitting a laser beam and for mechanically supporting the laser diode element on the planar major surface thereof with a support member interposed therebetween, and a sealing resin layer allowing the laser beam to pass therethrough and covering at least the laser diode element on the lead frame in a sealing manner, is improved according to the characterising features of claims 1 to 9.

There are many causes producing displacement of the light emitting point of a laser diode element. The inventors of the present patent application paid particular attention to the thermal expansion cf the sealing resin layer, which results from the heat generated when the laser diode element operates. In the present invention, the displacement of the lead frame, which is most sensitive to thermal expansion of the sealing resin layer, is minimized in order to obtain less displacement of the light emitting point.

Also in the present invention, the sealing resin layer is shaped symmetrically with respect to the lead frame. Consequently, forces exerted on the lead frame resulting from horizontal and vertical thermal expansion of the sealing resin layer can be distributed uniformly. As a result, distortion of the lead frame owing to differences in thermal expansion is considerably reduced. Hence, less displacement of the light omitting point is obtained.

Fixing the lead frame to an external fixing board can remove the influence of thermal expansion of the sealing resin layer and minimize light emitting point displacement. The lead frame fixing means may include an uncovered surface of the lead frame, which provides a mounting surface for placement against the external fixing board. When the mounting surface is the uncovered surface of the lead frame, the heat generated when the laser diode element operates can be effectively transferred from the resin sealing layer through the lead frame to the external fixing board. Therefore, thermal expansion of the sealing resin layer is reduced to minimize the influence of thermal expansion on the lead frame.

The fixing means may include at least one through-hole formed in the uncovered lead frame. In this case, fasteners of low thermal expansion are inserted into the through-hole to affix the lead frame to an external fixing board.

To gain less displacement of the light emitting point, the thickness of the sealing resin layer, that is, the separation or distance of the resin layer from the external fixing board, may be selected so that displacement of the lead frame falls within a tolerable range.

BRIEF DESCRIPTION OF THE DRAWINGS

The accompanying drawings, which are incorporated in and constitute a part of this specification, illustrate embodiments of the invention and, together with the description, serve to explain the objects, advantages and principles of the invention. In the drawings:

Fig. 1A is a cross sectional view of a semiconductor laser device according to a first embodiment of the present invention, which is taken along line 1A-1A in Fig. 1B;

Fig. 1B is a cross sectional view taken along line 1 B-1B of Fig. 1A;

Fig. 2 is a graph comparatively showing variations of the extent of displacement of a light emitting point versus operating time in a conventional laser device and the laser device of Fig. 1;

Fig. 3 is a perspective view of a rectangularly shaped semiconductor laser device, which is manufactured using the same technique as for the laser device of Fig. 1;

Fig. 4A is a side view, partially in cross section, of a semiconductor laser device according to a second embodiment of the present invention;

Fig. 4B is a cross section view taken along line 4B-4B of Fig. 4A;

Fig. 5A is a side view showing a semiconductor laser device according to a third embodiment of the present invention;

Fig. 5B is a cross section view taken along line 5B-5B of Fig. 5A;

Fig. 6 is a perspective view, partially broken away, of a conventional semiconductor laser device of the can-type;

Fig. 7A is a front view of the semiconductor laser device shown in Fig. 6;

Fig. 7B is a cross sectional view taken along line 7B-7B in Fig. 7A;

Fig. 8 is a perspective view of a semiconductor laser device of the mold-type;

Fig. 9 is a perspective view showing the structure of a laser diode element used in the semiconductor laser device of Fig. 8;

Fig. 10 is a cross sectional view taken along line 10-10 of Fig. 9;

Fig. 11 is a cross sectional view of a semiconductor laser device of the mold-type;

Fig. 12A is a plan view of the semiconductor laser device shown in Fig. 8;

Fig. 12B is a cross sectional view taken abng line 12B-12B of Fig. 12A;

Fig. 13A is a perspective view showing an optical system of a pick-up device for an optical disc, which uses a semiconductor laser device;

Fig. 13B is an explanatory diagram showing the construction of a light sensor contained in the optical system of Fig. 13A;

Fig. 14 is a graph showing displacement of the light emitting point of a semiconductor laser device in the X direction versus device operating time;

Fig. 15 is a diagram of a one-dimensional simulation for examining displacement of the light emitting point in a pick-up device for a compact disc;

Fig. 16A is a graphical representation of simulated pickup device light distributions U1, U2, U3, U4 and U5 $+\Delta$ when $\Delta X = 0$;

Fig. 16B is a graphical representation of simulated pick-up device light distributions as in Fig. 16A when $\Delta X = 1$ $\mu$m;

Fig. 17 is a graph showing the relationship between shifts of the gravity center of a beam spot and displacements of the light emitting point, which result from the simulations of Figs. 16A and 16B;

Fig. 18A is a side view showing a semiconductor laser device according to a second embodiment of the invention, in which a sealing resin layer covers only a laser diode element and a phot diode;

Fig. 18B is a cross sectional view taken along line 18B-18B of Fig. 18A;

Figs. 19A to 19E are cross sectional views showing specific examples of fixing means used for a semiconductor laser device;

Fig. 20A is a side view showing a semiconductor laser device according to a third embodiment of the present invention;

Fig. 20B is a cross sectional view taken along line 20B-20B of Fig. 20A;

Fig. 21A is a side view, partly in cross section, showing a structure for fixing the laser device of Figs. 20A and 20B to a fixing board;

Fig. 21B is a side view, partly in cross section, showing another structure for fixing the laser device of Figs. 20A and 20B to a fixing board;

Fig. 22 is a view showing a semiconductor laser device according to a second embodiment of the invention where the lead frame is not covered by the sealing resin layer; and

Fig. 23 is a perspective view showing the semiconductor laser device according to the second embodiment where the lead frame is not covered by the sealing resin layer.

## DETAILED DESCRIPTION OF THE PREFERRED EMBODIMENTS

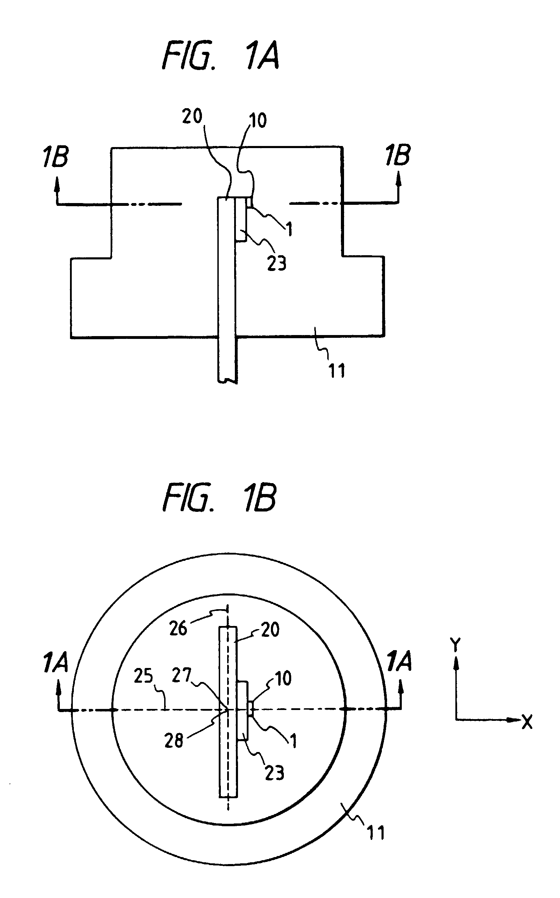

Figs. 1A and 1B cooperate to show the construction of a semiconductor laser device according to a first embodiment of the present invention, which is of the mold-type already generally described with reference to Fig. 12.

As shown, a laser diode element 1, which has end-face destruction preventing layers 10, as best seen in Fig. 10, is secured to a lead frame 20, with a photo diode 23 interposed therebetween. The lead frame 20 mechanically supports and electrically controls the laser diode element 1 and the photo diode 23. The photo diode 23 also serves as a submount and a radiator plate for laser diode element 1. The assembly of the laser diode element 1, the photo diode 23, and the lead frame 20 is encapsulated with a sealing resin layer 11 made of transparent epoxy resin. Like or equivalent portions of the laser device of Fig. 1 will be designated by like reference numerals used in the drawings illustrating the conventional laser devices and other embodiments of the invention.

It is to be noted that an intersection point 27 of a center line 25 of the sealing resin layer 11, which extends in the horizontal direction (perpendicular to the lead frame major planar surface, and referred to as an X-axis direction) and a center line 26 in the vertical direction (parallel to the plane of the lead frame major planar surface, and referred to as a Y-axis direction) is coincident with a center 28 of the lead frame 20. However, as noted earlier, the center 27 of the sealing resin layer 11 is displaced from the center 28 of the lead frame 20 by an offset 29 (Fig. 12A). Specifically, in the cross section of Fig. 1B, which is parallel to the light-emitting end face of the laser diode element 1 on which the end-face destruction preventing layer 10 is formed, the Y axis 26 defining the vertical direction and the X axis 25 defining the horizontal direction, respectively, are coincident with the horizontal and vertical center lines of the sealing resin layer. Thus, the sealing resin layer 11 is formed symmetrically with respect to the X axis 25 and the Y axis 26. Therefore, the thickness of the sealing resin layer 11 around the lead frame 20 is uniform, i.e., the resin sealing layer is symmetrical about the lead frame. Consequently, the distribution of thermal stresses or forces on the lead frame 20, which are caused by heat generated by the laser beam emission, are balanced and generally cancelled out. Accordingly, displacement of the lead frame 20 may be limited by the shapes of the lead frame 20, the photo diode 23 and the laser diode element 1. Therefore, displacement of the lead frames 20 can be markedly reduced as compared to conventional devices. Hence, displacement of the light emitting point of the laser diode element 1 mounted by the lead frame 20 can be minimized. To make the center 28 of the lead frame 20 coincident with the center 27 of the sealing resin layer 11, the laser diode element 1 must be displaced from the center 27 of the sealing resin layer 11. The optical nature of the sealing resin layer 11 is uniform throughout, and thus laser performance remains unchanged. As described above, the displacement of the light emitting point is caused by differences in the thermal expansion coefficients of the resin and the lead frame when these members are heated by the heat generated by operation of the laser element. The term "symmetrical sealing resin layer", used herein, involves the resin layer having such a shape as to affect the lead frames, but it is not intended to limit an external form of the resin that can be considered to have little or no affect on the lead frame.

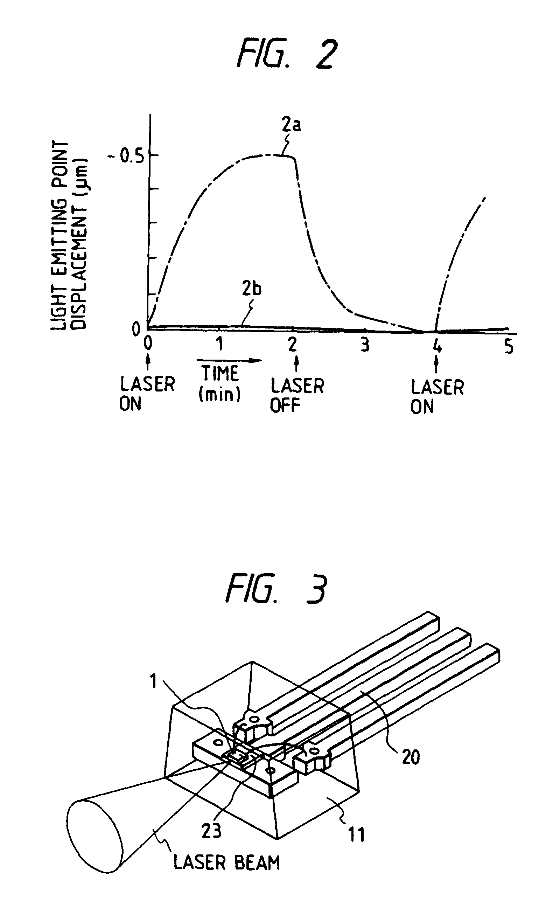

Turning now to Fig. 2, there is shown a graph comparatively showing variations of displacement of the light emitting point in a conventional laser device and the laser device of Fig. 1 with respect to operating time. In the measurement, the semiconductor laser devices were operated at room temperature with an operating current of 50 mA.

As seen from Fig. 2, in the conventional semiconductor laser device, after the laser device is turned on for about two minutes the light emitting point shifted 0.5 $\mu$m in the X direction, i.e., toward the lead frame 20 (curve 2a). on the other hand, in the semiconductor laser device of the invention, the light emitting point shifts minimally, i.e., less than 0.05 $\mu$m (curve 2b). This demonstrates that coincidence of the center 28 of the lead frame 20 with the center 27 of the sealing resin layer 11 minimizes shifting of the light emitting point. When the laser device of the present embodiment is utilized in an optical pick-up device, a shift of the beam spot on the photo diode is minimized, as shown in Fig. 16A.

Thus, the use of the sealing resin layer 11 shaped to be symmetrical with respect to the center lines 25 and 26 of the lead frame 20 succeeds in removing the affects of thermal expansion on the lead frame 20, and hence displacement of the light emitting point is minimized.

The first embodiment has been described using the tubular-shaped semiconductor laser device of the mold-type. It is evident that the present invention is also applicable to flat-shaped semiconductor laser device of the mold-type as shown in Fig. 3, if the sealing resin layer 11 is shaped substantially symmetrical with respect to the center lines within the region near the lead frame 20, which experiences the largest temperature increase.

The flat-shaped semiconductor laser device shown in Fig. 3 has the same construction as the above-mentioned semiconductor laser device, except for the shape of the sealing resin layer 11. Accordingly, no further description of the laser device will be given.

In the first embodiment described above, the shape of the lead frame is rectangular in cross section. If required, it may have other cross sectional shapes. Particularly in the case where the vertical and horizontal center lines cannot be strictly defined, those center lines may be those center lines that are substantially parallel to the major surfaces of the lead frame.

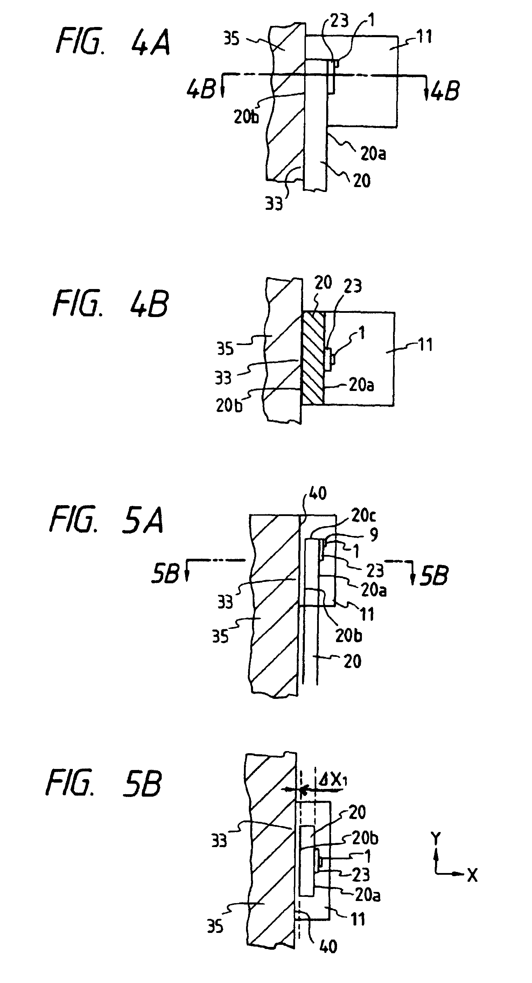

A semiconductor laser device according to a second embodiment of the present invention will be described with reference to Figs. 4A and 4B. The semiconductor laser device of the second embodiment, like the first embodiment, is also of the mold-type.

As shown, a laser diode element 1 having end-face destruction preventing layers is mounted to a photo diode 23, which, in turn, is mounted to the major planar surface of a lead frame 20. The lead frame 20 mechanically supports and electrically controls the laser diode element 1 and the photo diode 23. The photo diode 23 also serves as a submount and a radiator plate.

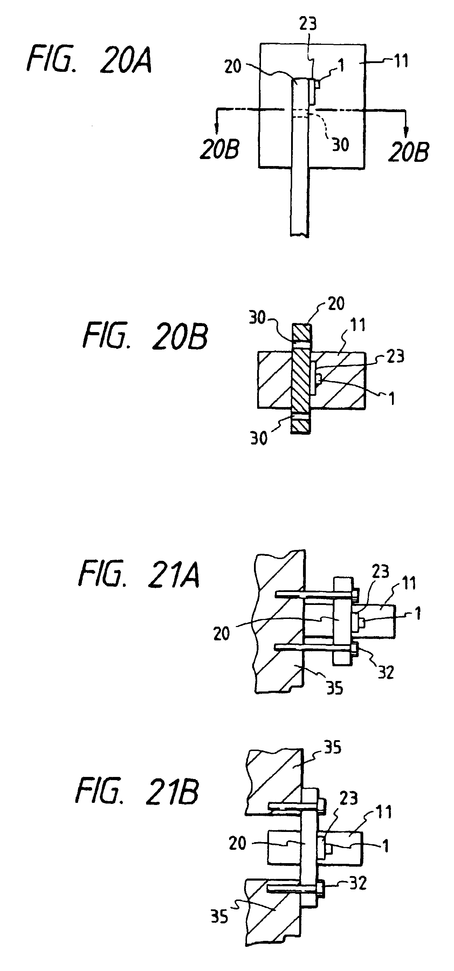

In the second embodiment, the laser diode element 1 and photo diode 23 are mounted on surface 20a of the lead frame 20. The surface 20b of the lead frame 20, opposed to surface 20a, is exposed. Specifically the sealing resin layer 11 extends over the surface 20a of the lead frame 20, the laser diode element 1 and the photo diode 23. The surface 20b is not covered with the sealing resin layer 11. Accordingly, the semiconductor laser device may be affixed to a fixing board 35 with surface 20b of the lead frame bonded to the fixing board 35 by an adhesive 33. Alternatively, through-holes in the lead frame 20 may be used for this fixing purpose, as in the third embodiment to be described in conjunction with Figs. 20 and 21. Since the laser device, thus constructed, is immovable relative to the fixing board 35, no displacement of the laser device with respect to the fixing board takes place. While the sealing resin layer 11 is placed over only surface 20a of the lead frame 20, the thermal expansion of the sealing resin layer 11 has little influence on the lead frame 20, since the lead frame 20 can not move when the temperature of the sealing resin layer 11 rises during operation of the laser device. This contributes to a reduction in displacement of the light emitting point. The effects of the second embodiment were measured under the same conditions as those in the first embodiment, and the results were as shown in Fig. 2.

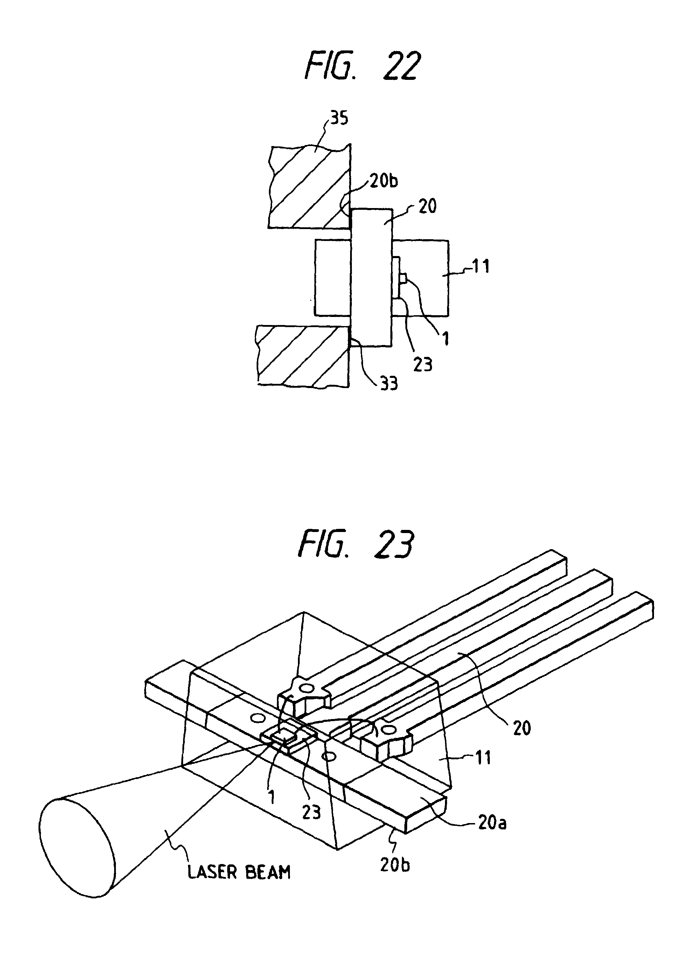

While a semiconductor laser device of the mold-type having a rectangular sealing resin layer 11 has been described, the semiconductor laser device may be variously modified if the uncovered surface 20b of the lead frame is fixed in place. For example, a semicircular sealing resin layer may be used for the sealing resin layer 11. In modifications of the laser device illustrated in Figs. 18 and 22, the sealing resin layer 11 covered only the laser diode element 1 and the photo diode 23, and the neighboring region. The laser device of Fig. 22 is bonded to a fixing board 35 by adhesive at a surface of the lead frame not covered with the sealing resin layer. A practical embodiment of the laser device of Fig. 22 is illustrated in perspective in Fig. 23.

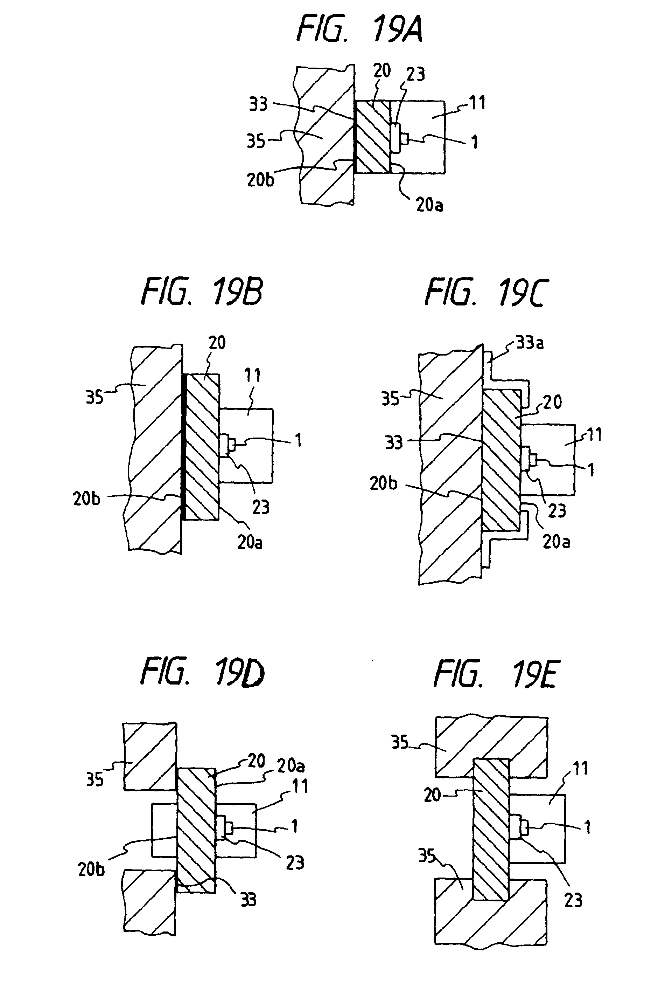

A possible way of affixing the laser device to the fixing board is to bond an exposed surface of the lead frame to the fixing board. Additional examples of ways to fix the laser device to the fixing board will be described with reference to Figs. 19A to Fig. 19E.

In Fig. 19A, the sealing resin layer 11 covering the laser diode element 1 and the photo diode 23, which are mounted on the lead frame 20, has a width equal to that of the lead frame 20. The uncovered surface 20b of the lead frame 20 isbonded to the fixing board 35 by adhesive 33.

To increase the bonding surface, the width of the lead frame 20 is made larger than the width of the sealing resin layer 11, as shown in Fig. 19B.

In Fig. 19C, the same laser device of Fig. 19B is fixed to the fixing board 35 by adhesive and fixing jigs 33a.

In Fig. 19D, the portion of the lead frame not covered with the sealing resin layer 11 is bonded to the fixing board 35 by adhesive 33.

In Fig. 19E, the same laser device as in Fig. 19B or 19C is captured in a recess of the fixing board 35.

In these fixing apparatus, the lead frame 20 and the fixing board 35 are made of material of good thermal conductivity. Thus heat generated by laser operation can be readily transferred to the fixing board 35 at low thermal resistance, thereby providing good heat dissipation. Accordingly, temperature rise of the sealing resin layer 11 is reduced, and thus displacement of the light emitting point is further reduced.

A semiconductor laser device according to a third embodiment of the present invention will be described with reference to Figs. 20A, 20B, 21A and 21B. The semiconductor laser device of this third embodiment is also of the mold-type.

As shown in Figs. 20A and 20B, a laser diode element 1 having end-face destruction preventing layers is secured to a lead frame 20 by way of an interposed photo diode 23. Again, the lead frame 20 mechanically supports and electrically controls the laser diode element 1 and the photo diode 23. The assembly of those elements is covered with a sealing resin layer 11.

In this third embodiment, two fixing through-holes 30 are formed in the lead frame. As best illustrated in Fig. 20B, those through-holes 30 are located on opposite sides of the sealing resin layer 11 covering the assembly.

Two examples of mounting semiconductor laser board devices to a fixing board are illustrated in Figs. 21A and 21B. In those examples, bolts 32 are used to affix the lead frame 20 to the fixing board 35. Material of relatively low thermal expansion coefficient and good thermal conductivity, such as solder and resin, may be used in place of bolts.

The displacement of the light emitting point in the semiconductor laser device of this embodiment was measured under substantially the same conditions as those in the first embodiment. The displacement quantities measured were comparable those plotted in Fig. 2.

The semiconductor laser device illustrated in the third embodiment incudes a rectangular sealing resin layer 11. However, the sealing resin layer 11 may take other shapes, such as an asymmetrical shape, if the lead frame 20 has through-holes 30 for fixing the laser device to the fixing board 35.

A mold-type semiconductor laser device according to a fourth embodiment of the present invention will be described with reference to Figs. 5A and 5B.

As shown in Fig. 5A, a laser diode element 1 having end-face destruction preventing layers is secured to a lead frame 20, again by way of interposed photo diode 23. The lead frame 20 mechanically supports and electrically controls the laser diode element 1 and the photo diode 23. An end face 20c of the lead frame lies in a plane containing a light emitting end face 9 of the laser diode element 1. The assembly of those elements is covered with a sealing resin layer 11.

In the fourth embodiment, the surface 40 of the sealing resin layer 11 lying above the surface 20b of the lead frame 20, which is opposed to the surface 20a to which the laser diode element 1 and the photo diode 23 are mounted, is placed against the fixing board 35 when the semiconductor laser device is fixed to the fixing board. Distance $\Delta X1$ between the surfaces 40 and 20b is kept constant over those surfaces.

As seen from Fig. 16, showing the results of the simulation in a pick-up optical system, when the displacement of the light emitting point is $\Delta X$, the beam spot shift on the photo diode is highly magnified.

To cope with this, the distance $\Delta X1$ is selected so as to satisfy the following equation:

$$\Delta X1 \leq (\Delta L/M)/(\alpha \times \Delta T) \tag{1}$$

where $\alpha$ indicates linear expansion coefficient of the sealing resin layer, and $\Delta T$ indicates the change in ambient temperature. $\Delta L$ represents a tolerable shift of the beam spot on the divided photo diodes of the pickup device of the type in which a semiconductor laser device is used as a reproduction light source in an optical disc system. M is an image forming magnification factor defined by the magnification of a lens system, including at least one lens, which is located along the distance of an optical path between the light emitting point of a laser diode element and the divided photo diode of a pick-up device.

Specifically, when transport epoxy resin is used for the sealing resin layer, which is essential to the present invention, its linear expansion coefficient a is 5 to 7 x $10^{-5}$/°C. Under conditions where ambient temperature change $\Delta T$ is within -10 to 60 °C, the tolerance $\Delta I$ of the beam spot shift is 10 $\mu$m, the magnification M is 8, and the linear expansion coefficient $\alpha$ is 6 x $10^{-5}$/°C, the formula (1) indicates that the distance $\Delta X1$ must be
$\Delta X1 \leq 0.2$ mm.

The magnification M and the beam spot shift tolerance $\Delta L$ depend on the optical system used. The ambient temperature change $\Delta T$ also depends on the application. When an optical disc system is installed in a vehicle, the temperature change $\Delta T$ ranges from -15 to 70 ° C. As a matter of course, the distance $\Delta X1$ is again defined by the formula (1).

When the semiconductor laser device is fixed to the fixing board 35 in a manner that the mounting surface 40 of the sealing resin layer is placed against the fixing board 35, the displacement of the lead frame 20 relative to the fixing board 35 depends on only the influence of the sealing resin layer 11 on the lead frame, which is separated from the mounting surface 40 by the distance $\Delta X1$, as seen in Fig. 5B.

All of the semiconductor laser devices thus far described satisfy the tolerable value of the beam spot shift on the photo diode that is acceptable in pick-up devices for compact discs. Thus, the present invention succeeds in realizing a semiconductor laser device which is inexpensive and can be of various shapes, by using the semiconductor laser devices of the mold-type. Further, in terms of light emitting point stability, the semiconductor laser device of the invention is comparable with semiconductor laser devices of the can-type.

As seen from the foregoing description, displacement of the lead frame, which is caused by thermal expansion of the sealing resin layer, can be minimized by using a sealing resin layer that is shaped symmetrically with respect to the lead frame, or by fixedly mounting the lead frame to an external fixing board, with the portion of the sealing resin layer providing the surface affixed to the fixing board having a limited thickness. Accordingly, the displacement of the laser diode element, which is fixed to the lead frame, is minimized during operation of the laser device. Consequently, displacement of the light emitting point can be considerably reduced. The mold-type semiconductor laser device of the invention, which is low in cost and conducive to various shapes, is also excellent in light emitting point stability. Thus, the present invention enables the semiconductor laser device of the mold-type to be applied, without any additional position-correcting mechanism, in optical devices requiring high stability of the light emitting point, such as pick-up devices for compact discs. Recently semiconductor devices of the mold-type have found a variety of applications because of the beneficial features of low cost and flexible shaping. The present invention further increases the applications for mold-type semiconductor laser devices.

The foregoing description of preferred embodiments of the invention has been presented for purposes of illustration and description. It is not intended to be exhaustive or to limit the invention to the precise form disclosed, and modifications and variations are possible in light of the above teachings or may be acquired from practice of the invention. The embodiments were chosen and described in order to explain the principles of the invention and its practical application to enable one skilled in the art to utilize the invention in various embodiments and with various modifications as are suited to the particular use contemplated.

**Claims**

1. A semiconductor laser device having a lead frame (20) for electrically controlling a laser diode element (1) having at least one end face (9) for emitting a laser beam and for mechanically supporting the laser diode element (1) on a planar major surface (20a) thereof with a support member (23) interposed therebetween and a sealing resin layer (11) allowing the laser beam to pass therethrough and covering the laser diode element (1), the support member (23) and at least partially the lead frame (20) in a sealing manner, wherein a cross section of the planar major surface of the lead frame (20) is parallel to the light emitting end face,
**characterized in that**
the center (27) of sectional planes through the resin layer (11) parallel to the light-emitting end face (9) of the laser diode element (1) coincides with the center (28) of said cross section of the planar major surface of the lead frame (20).

2. A semiconductor laser device according to claim 1,
**characterized in that** said sectional planes through the resin layer (11) have a horizontal (25) and vertical (25) center line, wherein the horizontal center line (25) extends perpendicular to the lead frame major planar surface (20a) and the vertical center line (26) extends parallel to the frame major planar surface (20a), wherein said sealing resin layer (11) being shaped symmetrically with respect to the vertical center line.

3. A semiconductor layer device according to claim 1 or 2,
**characterized in that**
said sectional planes through the resin layer (11) have a horizontal (25) and a vertical (26) center line, wherein the horizontal center line (25) extends perpendicular to the lead frame major planar surface (20a) and the vertical center line (26) extends parallel to the frame major planar surface (20a), wherein said sealing resin layer (11) being shaped symmetrically with respect to the horizontal center line.

4. A semiconductor laser device according to one of claims 1 to 3,
**characterized in that**
the laser diode element (1) being supported at the center of the lead frame (20) when viewed in the horizontal direction.

5. The semiconductor laser device according to one of claims 1 to 4, which further includes means for fixing the semiconductor laser device (1) to an external fixing board (35).

6. The semiconductor laser device according to claim 5, wherein the fixing means includes at least one through-hole (30) formed in a portion of the lead frame (20) uncovered by the sealing resin layer.

7. The semiconductor laser device according to any one of claims 5 or 6, wherein the fixing means includes an adhesive.

8. The semiconductor laser device according to claim 6, wherein the fixing means includes connecting means (32) passing through the through-hole (30).

9. A semiconductor laser device having a lead frame (20) for electrically controlling a laser diode element (1) having at least one end face (9) for emitting a laser beam and said lead frame (20)also mechanically supporting the laser diode element (1) on a planar major surface (20a) thereof with a support member (23) interposed therebetween, and a sealing resin layer (11) allowing the laser beam to pass therethrough and covering the laser diode element (1), the support member (23), and at least partially the lead frame (20) in a sealing manner, wherein the end face (20c) of the lead frame lies in a plane containing the light-emitting diode end face (9), said plane having a horizontal (25) and a vertical (26) center line. wherein the horizontal center line (25) extends perpendicular to the lead frame major planar surface (20a) and the vertical center line (26) extends parallel to the frame major planar surface (20a),
**characterized in that**
a mounting surface (40) of the sealing resin layer (11), for being mounted against an external fixing board (35) is uniformly separated from a surface (20b) of the lead frame (20), parallel and opposite to said planar major surface

(20a). by distance $\Delta X1 \leq 0.2$ (mm).

**Patentansprüche**

1. Eine Halbleiterlasereinrichtung, die einen Anschlußrahmen (20) zum elektrischen Steuern eines Laserdiodenelements (1), das mindestens eine Endseite (9) zum Aussenden eines Laserstrahls aufweist, und zum mechanischen Halten des Laserdiodenelements (1) an einer ebenen Hauptoberfläche (20a) davon mit einem Halteelement (23), das dazwischengefügt ist, und eine abdichtende Kunstharzschicht (11) aufweist, die den Laserstrahl hindurchgehen läßt und das Laserdiodenelement (1), das Halteelement (23) und mindestens teilweise den Anschlußrahmen (20) auf eine dichte Weise überdeckt, worin ein Querschnitt der ebenen Hauptoberfläche des Anschlußrahmens (20) parallel zu der lichtaussendenden Endseite ist,
   **dadurch gekennzeichnet,**
   daß die Mitte (27) von Schnittebenen durch die Kunstharzschicht (11), parallel zu der lichtaussendenden Endseite (9) des Laserdiodenelements (1) mit der Mitte (28) des genannten Querschnitts der ebenen Hauptoberfläche des Anschlußrahmens (20) zusammenfällt.

2. Eine Halbleiterlasereinrichtung gemäß Anspruch 1, **dadurch gekennzeichnet**, daß die genannten Schnittebenen durch die Kunstharzschicht (11) eine horizontale (25) und vertikale (26) Mittellinie aufweisen, worin sich die horizontale Mittellinie (25) senkrecht zu der ebenen Hauptoberfläche (20a) des Anschlußrahmens fortsetzt und sich die vertikale Mittellinie (26) parallel zu der ebenen Hauptoberfläche (20a) des Anschlußrahmens fortsetzt, wobei die genannte abdichtende Kunstharzschicht (11) symmetrisch in bezug auf die vertikale Mittellinie geformt ist.

3. Eine Halbleiterlasereinrichtung gemäß Anspruch 1 oder 2,
   **dadurch gekennzeichnet,**
   daß die genannten Schnittebenen durch die Kunstharzschicht (11) eine horizontale (25) und vertikale (26) Mittellinie aufweisen, worin sich die horizontale Mittellinie (25) senkrecht zu der ebenen Hauptoberfläche (20a) des Anschlußrahmens fortsetzt und sich die vertikale Mittellinie (26) parallel zu der ebenen Hauptoberfläche (20a) des Anschlußrahmens fortsetzt, wobei die genannte abdichtende Kunstharzschicht (11) symmetrisch in bezug auf die horizontale Mittellinie geformt ist.

4. Eine Halbleiterlasereinrichtung gemäß einem der Ansprüche 1 bis 3,
   **dadurch gekennzeichnet,**
   daß das Laserdiodenelement (1) bei der Mitte des Anschlußrahmens (20) gehalten ist, wenn in der horizontalen Richtung betrachtet wird.

5. Die Halbleiterlasereinrichtung gemäß einem der Ansprüche 1 bis 4, die ferner eine Einrichtung zum Befestigen der Halbleiterlasereinrichtung (1) an einer äußeren Befestigungsplatte (35) aufweist.

6. Die Halbleiterlasereinrichtung gemäß Anspruch 5, worin die Befestigungseinrichtung mindestens ein Durchgangsloch (30) einschließt, das in einem Abschnitt des Anschlußrahmens (20) gebildet ist, der von der abdichtenden Kunstharzschicht unbedeckt ist.

7. Die Halbleiterlasereinrichtung gemäß einem der Ansprüche 5 oder 6, worin die Befestigungseinrichtung ein Klebemittel einschließt.

8. Die Halbleiterlasereinrichtung gemäß Anspruch 6, worin die Befestigungseinrichtung eine Verbindungseinrichtung (32) einschließt, die durch das Durchgangsloch (30) hindurchgeht.

9. Eine Halbleiterlasereinrichtung, die einen Anschlußrahmen (20) zum elektrischen Steuern eines Laserdiodenelements (1), das mindestens eine Endseite (9) zum Aussenden eines Laserstrahls aufweist, und zum mechanischen Halten des Laserdiodenelements (1) an einer ebenen Hauptoberfläche (20a) davon mit einem Halteelement (23), das dazwischengefügt ist, und eine abdichtende Kunstharzschicht (11) aufweist, die den Laserstrahl hindurchgehen läßt und das Laserdiodenelement (1), das Halteelement (23) und mindestens teilweise den Anschlußrahmen (20) auf eine dichte Weise überdeckt, worin die Endseite (20c) des Anschlußrahmens (20) in einer Ebene liegt, die die lichtaussendende Diodenendseite (9) enthält, wobei die genannte Ebene eine horizontale (25) und eine vertikale (26) Mittellinie aufweist, wobei sich die horizontale Mittellinie (25) senkrecht zu der ebenen Hauptoberfläche (20a) des Anschlußrahmens erstreckt und sich die vertikale Mittellinie (26) parallel zu der ebenen Hauptoberfläche (20a) des Rahmens erstreckt,

**dadurch gekennzeichnet,**

daß eine Befestigungsoberläche (40) der abdichtenden Kunstharzschicht (11), um gegen eine äußere Befestigungsplatte (35) befestigt zu werden, gleichförmig von einer Oberfläche (20b) des Anschlußrahmens (20), die parallel und entgegengesetzt zu der genannten ebenen Hauptoberfläche (20a) ist, um eine Strecke $\Delta X1 \leq 0{,}2$ (mm) getrennt ist.

**Revendications**

1. Dispositif de laser à semi-conducteur possédant un cadre conducteur (20) pour la commande électrique d'un élément de diode laser (1) possédant au moins une face d'extrémité (9) pour l'émission d'un faisceau laser et pour le support mécanique de l'élément de diode laser (1) sur sa surface plane principale (20a), une pièce de support (23) étant interposée et une couche de résine d'encapsulation (11) permettant au faisceau laser de traverser et recouvrant l'élément de diode laser (1), la pièce de support (23) et au moins partiellement le cadre conducteur (20) de façon étanche, une section droite de la surface plane principale du cadre conducteur (20) étant parallèle à la face d'extrémité d'émission de la lumière,

   dispositif caractérisé en ce que le centre (27) des plans de section dans la couche de résine (11) parallèle à la face d'extrémité d'émission de lumière (9) de l'élément de diode laser (1) coïncide avec le centre (28) de ladite section droite de la surface plane principale du cadre conducteur (20).

2. Dispositif de laser à semi-conducteur selon la revendication 1, caractérisé en ce que lesdits plans de section dans la couche de résine (11) possèdent des lignes de centre horizontale (25) et verticale (26), la ligne de centre horizontale (25) s'étendant, de façon normale, à la surface plane principale de cadre conducteur (20a) et la ligne de centre verticale (26) s'étendant, de façon parallèle, à la surface plane principale de cadre (20a), ladite couche de résine d'encapsulation (11) étant conformée, de façon symétrique, par rapport à la ligne de centre verticale.

3. Dispositif de laser à semi-conducteur selon la revendication 1 ou 2, caractérisé en ce que lesdits plans de section dans la couche de résine (11) possèdent des lignes de centre horizontale (25) et verticale (26), la ligne de centre horizontale (25) s'étendant, de façon normale, à la surface plane principale de cadre conducteur (20a) et la ligne de centre verticale (26) s'étendant, de façon parallèle, à la surface plane principale de cadre (20a), ladite couche de résine d'encapsulation (11) étant conformée, de façon symétrique, par rapport à la ligne de centre horizontale.

4. Dispositif de laser à semi-conducteur selon l'une quelconque des revendications 1 à 3, caractérisé en ce que l'élément de diode laser (1) est supporté au centre du cadre conducteur (20) en vue dans la direction horizontale.

5. Dispositif de laser à semi-conducteur selon l'une quelconque des revendications 1 à 4, comprenant, de plus, un moyen pour la fixation du dispositif de laser à semi-conducteur (1) sur une plaque externe de fixation (35).

6. Dispositif de laser à semi-conducteur selon la revendication 5, dans lequel le moyen de fixation comprend au moins un trou traversant (30) formé dans une partie du cadre conducteur (20) non recouverte par la couche de résine d'encapsulation.

7. Dispositif de laser à semi-conducteur selon la revendication 5 ou 6, dans lequel le moyen de fixation comprend un adhésif.

8. Dispositif de laser à semi-conducteur selon la revendication 6, dans lequel le moyen de fixation comprend un moyen de connexion (32) traversant le trou traversant (30).

9. Dispositif de laser à semi-conducteur possédant un cadre conducteur (20) pour la commande électrique d'un élément de diode laser (1) possédant au moins une face d'extrémité (9) pour l'émission d'un faisceau laser et pour le support mécanique de l'élément de diode laser (1) sur sa surface plane principale (20a), une pièce de support (23) étant interposée et une couche de résine d'encapsulation (11) permettant au faisceau laser de traverser et recouvrant l'élément de diode laser (1), la pièce de support (23) et au moins partiellement le cadre conducteur (20) de façon étanche, la face d'extrémité (20c) dudit cadre conducteur (20) s'étendant dans un plan contenant la face d'extrémité d'émission de lumière (9), ledit plan possédant une ligne de centre horizontale (25) et une ligne de centre verticale (26), la ligne de centre horizontale (25) s'étendant, de façon normale, à la surface plane principale de cadre conducteur (20a) et la ligne de centre verticale (26) s'étendant, de façon parallèle, à la surface plane principale de cadre (20a),

dispositif caractérisé en ce qu'une surface de montage (40) de la couche de résine d'encapsulation (11), devant être montée contre une plaque externe de fixation (35), est séparée, de façon uniforme, d'une surface (20b) du cadre conducteur (20), de façon parallèle et opposée à ladite surface plane principale (20a), d'une distance $\Delta X1 \leq 0,2$ mm.

## FIG. 1A

## FIG. 1B

## FIG. 2

## FIG. 3

FIG. 4A

FIG. 4B

FIG. 5A

FIG. 5B

FIG. 7A
PRIOR ART

FIG. 7B
PRIOR ART

FIG. 6
PRIOR ART

EP 0 568 830 B2

FIG. 8

LASER
BEAM

1

23

20

21

20

11

FIG. 10

1

10

9

7

10

9

8

FIG. 11

10   B

1

23

11

20

FIG. 9

10

7

1

6

5

4

3

10

2   8

17

EP 0 568 830 B2

*FIG. 12A*

*FIG. 12B*

18

FIG. 13A

FIG. 13B

# FIG. 14

# FIG. 15

# FIG. 16B

# FIG. 16A

GRAVITY CENTER SHIFT +1.1μm (U₄, FIG. 16B)

GRAVITY CENTER SHIFT −7.9μm (U₅+Δ, ΔX=0, FIG. 16B)

U₅+Δ (0.3mm) (ΔX=1μm) (FIG. 16A)

GRAVITY CENTER SHIFT

GRAVITY CENTER SHIFT

# FIG. 17

# FIG. 18A

# FIG. 18B

## FIG. 19A

## FIG. 19B

## FIG. 19C

## FIG. 19D

## FIG. 19E

FIG. 20A

FIG. 20B

FIG. 21A

FIG. 21B

## FIG. 22

## FIG. 23

LASER BEAM